# EUROPÄISCHE PATENTSCHRIFT

(11) **EP 3 436 835 B1**
(45) Veröffentlichungstag und Bekanntmachung des Hinweises auf die Patenterteilung: **05.06.2024**
(21) Anmeldenummer: 17722656.0
(22) Anmeldetag: 29.03.2017
(51) Int. Cl.: G01R 29/08, A41D 1/00

(54) **SCHUTZKLEIDUNG**
PROTECTIVE CLOTHING
VÊTEMENT DE PROTECTION

(30) Priorität: 31.03.2016 DE 102016105860
(43) Veröffentlichungstag der Anmeldung: 06.02.2019
(73) Patentinhaber: Hochschule für Technik und Wirtschaft Berlin, 10318 Berlin (DE)
(72) Erfinder: GRÄF, Thomas, 12621 Berlin (DE)
(74) Vertreter: Bittner, Thomas L.
(86) Internationale Anmeldenummer: PCT/DE2017/100249
(87) Internationale Veröffentlichungsnummer: WO 2017/167331

(56) Entgegenhaltungen:
- WO-A1-2016/014260
- US-A- 6 080 690
- US-A1- 2009 309 604
- US-A1- 2012 199 755
- US-A1- 2015 145 671

## Beschreibung

Die Offenbarung betrifft eine Schutzkleidung.

### Hintergrund

Die Auswertung und Beobachtung der durch die Berufsgenossenschaft BG Energie Textil Elektro Medien - BG ETEM - nach Jahreszahlen veröffentlichten Unfallzahlen lässt verschiedene Analysen hinsichtlich der auftretenden Gefährdungen und Ursachen bei Elektrounfällen zu. Die Unfallzahlen steigen in den letzten Jahren an. Die Ursachen hierfür sind zum einen im Wirtschaftswachstum, zum anderen auch im immensen Zubau von regenerativen Erzeugereinheiten und der dort vorzufindenden Qualifikation und dem Kostendruck zu finden.

In der jüngeren Vergangenheit besteht im Bereich der Normengremien der DKE, auch auf internationaler Ebene, ein erheblicher Diskussionsbedarf hinsichtlich Maßnahmen beim Auftreten von Gefährdungen von Personen durch sogenannte "Innere Fehler" von Schaltanlagen. Diese "Inneren Fehler" werden auch Störlichtbögen genannt und sind in der Wirkung mit einer Explosion innerhalb der Schaltanlage vergleichbar. Die Ursachen hierfür können unterschiedlichster Art sein: Technisches Versagen, Fremdkörper z.B. Eindringen von Tieren oder menschliches Versagen z.B. durch Fehlhandlungen. Vorgaben existieren sowohl durch Normen aus dem Bereich der Elektrotechnik als auch durch gesetzliche Rahmenbedingungen wonach Vorkehrungen hinsichtlich der auftretenden Gefährdungen (Knall, Rauchgase, Brand, Wegschleudern von Teilen, Verbrennungen, Beibehaltung leitfähiger Erdungsverbindungen) durch den Anlagenhersteller als auch durch den Anlagebetreiber zu treffen sind.

Unter der Prämisse "Störlichtbogen"-(typ-)geprüfte und hergestellte Nieder- und Mittelspannungs-Schaltanlagen moderner Bauart sind so konzipiert, dass die Wirkung auf die Umgebung sowohl dem Personen- als auch dem Investitionsgüterschutz grundlegend genügt. Hohe Folgeschäden sollen durch konstruktive Maßnahmen innerhalb der Schaltanlagen vermieden werden.

Die durch die BG ETEM veröffentlichten Unfallzahlen sowie die Praxis zeigen, dass die Häufigkeit des Auftretens eines Störlichtbogens im Vergleich zum Berühren von Spannung führenden Teilen einer Schaltanlage sehr gering ist. Vielmehr ist die Zahl der Unfälle infolge des Berührens von spannungsführenden Teilen um ein Vielfaches höher.

Um Spannung führende Teile einer Schaltanlage berühren zu können, müssen diese Teile jedoch zugänglich sein, d.h., in aller Regel sind die Türen der Schaltanlagen dann geöffnet und es wird in unmittelbarer Umgebung der Schaltanlage oder an der Schaltanlagen gearbeitet. Nahezu 90 % der Unfälle treten im Bereich der Niederspannung auf. Die auftretenden Unfälle lassen sich weiter analysieren hinsichtlich der an oder in der Nähe der elektrischen Betriebsmittel durchgeführten Tätigkeiten. Dabei zeigt sich, sofern an den Anlagen aktiv gearbeitet wird, die Türen zu diesem Zweck an den Anlagen geöffnet sein müssen.

In diesem Fall sind die Schaltanlagen nicht mehr störlichtbogensicher, d.h., im Falle eines nun auftretenden Inneren Fehlers wird die gesamte freiwerdende Energie in das die Schaltanlage umgebende Umfeld abgegeben, was mit erheblichen (Personen-)Schäden und Kontaminierungen durch Abbrandprodukte einhergeht.

Bei einem Großteil der Unfälle im Bereich der Niederspannung erfolgt eine Körperdurchströmung, Störlichtbogen treten hingegen nur in wenigen Fällen auf.

Das Dokument EP 1 296 150 A1 offenbart einen tragbaren Detektor für elektrische Felder. In Abhängigkeit von dem erfassten elektrischen Feld wird ein Alarmsignal ausgelöst.

Das Dokument AT 503 677 A1 offenbart eine Arbeitsbekleidung für Schweißarbeiten mit einer Schweißanlage. Die Arbeitsbekleidung weist eine Analyseeinrichtung für einen oder mehrere Parameter auf. Die Analyseeinrichtung ist mit mehreren Sensoren gebildet, welche ein elektrisches Feld bestimmen und mit einer Auswerteeinrichtung verbunden sind. Nach Auswertung der Sensorsignale wird über eine Ausgabeeinrichtung ein Warnsignal ausgegeben. Dieses System dient zur Erkennung von gesundheitsgefährdenden Umgebungsbedingungen in der Weise dass die Einhaltung zulässiger Grenzwerte überwacht werden kann. Ziel der Schutzkleidung ist eine Verbesserung des Benutzungs- bzw. des Bedienkomforts von Schweißanlagen unterschiedlicher Technologie.

Das Dokument US 200910309604 A1 offenbart eine Vorrichtung zum Bestimmen einer elektrostatischen Entladung. Es wird anhand einer einfachen Kurve die Möglichkeit der Messung eines elektrischen Feldes aufgezeigt, eine dreidimensionale Bestimmung der Entfernung zum Spannung führenden Leiter erfolgt nicht. Damit kann keine Abschätzung eines Gefährdungspotenzials für Anwender hinsichtlich einer Körperdurchströmung erfolgen. In dem Dokument wird eine Messfrequenz von 1 Hz angesetzt, damit ist für die Messung in DC oder 50/60 Hz-Applikationen nicht geeignet. Vielmehr wird davon ausgegangen, dass eine Person sich bereits auf einem Potenzial befindet oder elektrostatisch aufgeladen ist.

Das Dokument US 5,532,681 A offenbart eine Warnvorrichtung für ein magnetisches Feld. Die Vorrichtung weist einen Magnetfeldsensor zum Bestimmen eines Magnetfeldes auf. Die messbaren Frequenzen sind im Bereich von 4 Hz bis 50 kHz angeben, damit ist eine Messung bei Gleichfeld nicht möglich. Darüber hinaus geht es um die Erkennung von hohen Magnetfeldern, die bei Feten zu Beeinflussungen führen können.

Das Dokument DE 10 2014 219 827 A1 offenbart eine Schutzschaltung mit einem Sensor und einem Signalgeber. Der Sensor erfasst mindestens eine physikalische und / oder chemische Umgebungsbedingung der Schutzschaltung. In Abhängigkeit der erfassten Umgebungsbeding wird der Signalgeber angesteuert. Die hier genannten Sensoren umfassen einen Sensor für einen elektrischen Kontakt, einen Spannungssensor, einen Stromsensor, einen Drucksensor, einen Temperatursensor, einen chemischen Sensor und einen elektrochemischen Sensor. Die Sensoren sind nicht in der Lage, ein elektrisches Feld zu messen. Mittels des chemischen und/oder elektrochemischen Sensors wird vorteilhafterweise eine Gaskonzentration ermittelt.

Das Dokument DE 10 2011 112 226 A1 offenbart eine integrierte Multisensor-Vorrichtung zur ortsaufgelösten, artefaktresistenten Überwachung von psychologischen Signalen.

Das Dokument DE 103 26 064 A1 offenbart einen berührungslosen Spannungsdetektor. Die Abmessung des Spannungsdetektors ist derart dimensioniert, dass der Spannungsdetektor am Körper getragen werden kann oder in Kleidung integriert werden kann. Der Spannungsdetektor erzeugt ein Alarmsignal, wenn ein elektrisches Feld erfasst wird.

Das Dokument DE 10 2015 206 608 A1 offenbart eine Sicherheitskleidung mit einer Sensoreinrichtung zur Erfassung einer bedienerspezifischen Kenngröße und / oder einer umgebungsspezifischen Kenngröße.

Das Dokument WO 2016/0142610 A1 offenbart ein System zum Erfassen von Spannungen, umfassend ein Kleidungsstück, das von einem Benutzer getragen wird und mehrere elektrische Feldsensoren umfasst, die jeweils in eine unterschiedliche Richtung weisen. Jeder Sensor umfasst einen Wandler, der ein elektrisches Feld beim Übertragen eines drahtlosen Signals erfasst, welches die Feldstärke für eine zugeordnete Richtung darstellt. Eine Alarmvorrichtung steht in operativer Kommunikation mit der Vielzahl von Sensoren und umfasst eine Steuerung, die eingerichtet ist, die Feldstärke für jeden Sensor zu überwachen und das Vorhandensein eines Alarmzustands als Reaktion darauf zu bestimmen, dass die Feldstärke oberhalb einer vorher festgelegten Schwelle liegt, und ein Alarmsignal zu erzeugen, das die zugehörige Richtung des Alarmzustands anzeigt.

Das Dokument US 2012/199755 A1 offenbart ein Verfahren und ein System, um eine quantitative Messung eines elektrischen Feldes vorzunehmen. Eine Vielzahl von Antennen, die durch bekannte Abstände voneinander getrennt sind, ist in einem Bereich angeordnet, der sich in mindestens einer Dimension erstreckt. Eine Spannungsdifferenz zwischen mindestens einem ausgewählten Antennenpaar wird gemessen. Jede Spannungsdifferenz wird durch den bekannten Abstand geteilt, der dem ausgewählten Antennenpaar zugeordnet ist, um eine resultierende Größe zu erzeugen. Die Vielzahl der resultierenden Größen, die über den Bereich definiert sind, beschreibt quantitativ ein elektrisches Feld darin.

Das Dokument US 6 080 690 A offenbart ein Textilgewebe mit mehreren elektrisch leitfähigen Fasern und mindestens einem elektronischen Sensor oder mehreren Sensorfasern. Das Textilgewebe ist zur Herstellung eines funktionellen Bekleidungsstücks oder eines anderen aus dem gewebten Textilgewebe hergestellten Gegenstands bestimmt. Das Gewebe soll einen Träger bei der Überwachung von biomedizinischen Informationen und/oder Umweltbedingungen unterstützen, die beim Träger bestehen. Die mehreren elektrisch leitfähigen Fasern und Erfassungsvorrichtungen sind dadurch gekennzeichnet, dass sie eine Verbindung zu einer tragbaren elektronischen Überwachungsvorrichtung, integrierten Komponenten wie Heiz- und Kühlbändern oder Elektronik herstellen oder als Antenne für Signale dienen, die zwischen einer integrierten elektronischen Komponente und einem Fernüberwachungsgerät empfangen und übertragen werden.

Das Dokument US 2015/145671 A1 offenbart ein oder mehrere Sensoren, die in einem Kleidungsstück eingebettet sind oder an diesem befestigt sind und erfassen, dass sich die Kleidung zu einem bestimmten Zeitpunkt in physischem Kontakt mit einem Benutzer befindet.

Aufgrund der hohen Unfallzahlen und dem dadurch verbundenen hohen Schaden sowohl für die Wirtschaft als auch für den Einzelnen ergibt sich die Notwendigkeit, die Wahrscheinlichkeit des Berührens von Spannung führenden Betriebsmitteln durch eine geeignete Hilfseinrichtung zu vermeiden.

### Zusammenfassung

Aufgabe ist es, verbesserte Technologie zum Vorbeugen von Unfällen bei Arbeiten an elektrischen Anlagen bereitzustellen.

Es ist eine Schutzkleidung nach Anspruch 1 offenbart. Weitere Ausführungsformen sind Gegenstand von abhängigen Ansprüchen.

An der Kleidung sind Sensoren angeordnet, die eingerichtet sind, eine elektrische Feldstärke zu bestimmen. Die Sensoren sind mit einer Recheneinrichtung verbunden, die eingerichtet ist, von den Sensoren ermittelte Messwerte auszuwerten und ein Signal abzugeben, falls ein vorbestimmter Schwellwert überschritten wird. Die Recheneinrichtung kann ebenfalls an der Kleidung angeordnet sein. An der Schutzkleidung sind mehr als zwei Sensoren angeordnet, beispielsweise drei, vier, fünf oder eine beliebige Anzahl. Die Sensoren können als separate Komponenten ausgeführt sein, die voneinander beabstandet an der Kleidung angeordnet sind. Es kann vorgesehen sein, dass mehrere Sensoren in einem gemeinsamen Gehäuse angeordnet sind. Auch eine Kombination von einem oder mehreren separaten Sensoren und mehreren Sensoren in einem Gehäuse ist möglich. Darüber hinaus können die Sensoren zur Bestimmung der elektrischen Feldstärke als Teilkomponenten eines Sensorkomplexes ausgeführt sein. Der Sensorkomplex kann weitere Sensoren aufweisen, die konfiguriert sind, andere Messgrößen zu bestimmen. Der Sensorkomplex kann in einem Komplexgehäuse angeordnet sein. Das elektrische Feld kann ein Gleichfeld oder ein Wechselfeld (mit beliebiger Frequenz sein).

Die Kleidung gestattet das Arbeiten in der Nähe von Spannung führenden Leitern. Sofern sich der dort Arbeitende zu sehr an einen Spannung führenden Leiter annähert, erfolgt eine Rückmeldung und Warnung, die durch einen Signalmelder an den Betroffenen oder auch an eine übergeordnete Stelle als Unfallmeldung weitergeleitet werden kann.

Spannungsführende Leiter sind von einem elektrischen Feld umgeben. Dieses elektrische Feld nimmt mit der Entfernung vom Leiter ab. Damit ergibt sich ein Gradient in allen drei Raumrichtungen, der durch die Sensoren ausgemessen werden kann. Die Recheneinrichtung ist eingerichtet, aus den Messwerten einen Gradienten eines elektrischen Feldes bezüglich einer räumlichen Orientierung zu bestimmen. Die Recheneinrichtung kann weiterhin konfiguriert sein, aus dem Gradienten des elektrischen Feldes einen Abstand zu einem ein Potenzial führenden Leiter oder Betriebsmittel zu bestimmen. Dies ermöglicht die Abschätzung eines Gefährdungspotenzials.

Die Sensoren und die Recheneinrichtung werden zusammen auch als Messsystem bezeichnet.

Die Schutzkleidung ermöglicht in einer Ausführungsform die Ermittlung eines Gefährdungspotenzials und eine dreidimensionale Berechnung eines Abstands von einem Spannung führenden Leiter. Es kann eine Gefährdungsbeurteilung mittels der implementierten des Messsystems erfolgen, die eine Berührung oder eine unzulässige Annäherung an Spannung führende Leiter/Betriebsmittel verhindert und / oder meldet. Darüber hinaus kann die Anbindung der Sensoren mittel metallischer als auch kunststofflicher Leiter, berührungssicher eingebettet in Gewebe, erfolgen.

Es kann vorgesehen sein, das Messsystem durch eine Kalibriermessung einmalig auf die jeweilige maximale Feldstärke einzustellen (z.B. Niederspannung 400 V, 690 V, 1000 V), Mittelspannung (1000 V bis 52 kV, z.B. 6,3 kV, 10 kV, 20 kV oder 30 kV), Hochspannung (52 kV bis 110 kV) oder Höchstspannung (110 kV bis 1200 kV, z.B. 110 kV, 220 kV, 380 kV) oder andere Wechsel- oder Gleichspannungen, die sich in unmittelbarer Nähe des Leiters ergibt. Je nach Spannungshöhe ist zu berücksichtigen, dass Mindestabstände einzuhalten sind, da auch durch Überschlag bei Annäherung ohne direkte Berührung eine Personengefährdung auftreten kann. Die Kalibriermessung kann sowohl bei Gleichspannung als auch bei Wechselspannung (mit beliebiger Frequenz) erfolgen.

Die Messung erfordert eine dreidimensionale Auswertung der Sensorsignale zur Bestimmung der Distanz zwischen den Sensoren und dem Spannung führenden Leiter. Damit lässt sich der Abstand des Nutzers von dem Leiter bestimmen und bei zu kleinem Sicherheitsabstand eine Warnmeldung generieren. Die Kleidung kann weiterhin eine Signalquelle aufweisen, die mit der Recheneinrichtung verbunden ist, wobei die Recheneinrichtung eingerichtet ist, ein Ausgabesignal an die Signalquelle abzugeben. Die Signalquelle kann eine Warnmeldung als akustisches, optisches oder haptisches (z.B. Vibration) Signal abgeben.

Das Messsystem kann an bzw. in die Schutzkleidung integriert sein.

Sensoren sind auf einem Sensorfeld angeordnet, so dass ein Abstand der Sensoren kleiner als 20 cm ist. Der Abstand der Sensoren kann kleiner als 10 cm, kleiner als 5 cm oder kleiner als 3 cm sein. Es können auch mehr als zwei Sensoren auf einem Sensorfeld angeordnet sein, beispielsweise drei, vier, fünf oder eine beliebige Anzahl von

Sensoren, derart, dass ein paarweiser Abstand der Sensoren kleiner als 20 cm, kleiner als 10 cm, kleiner als 5 cm oder kleiner als 3 cm ist. Das Sensorfeld kann in einem Gehäuse angeordnet sein.

An der Kleidung sind mehrere Sensorfelder angeordnet, wobei jedes Sensorfeld zwei, drei oder mehrere Sensoren aufweist, wobei für jedes Sensorfeld gilt, dass die zwei, drei oder mehrere Sensoren paarweise zueinander einen Abstand von weniger als 20 cm aufweisen. Auch kann der paarweise Abstand der Sensoren kleiner als 10 cm, kleiner als 5 cm oder kleiner als 3 cm sein.

Die Sensorfelder können in einem Handbereich, einem Fußbereich, einem Brustbereich und / oder einem Rückenbereich der Kleidung (sogenannten kritischen Bereichen) angeordnet sein.

Auch andere Anordnungen sind möglich und nicht ausgeschlossen.

Verbindungselemente, mittels derer die Sensoren mit der Recheneinrichtung verbunden sind, können von einem Gewebe der Kleidung umgeben sein, im Gewebe integriert sein oder das Gewebe der Kleidung selbst bilden. Die Verbindungselemente können als metallische Leiter, als Glasfasern und / oder als Kunststofffasern oder als leitfähige Textilfasern gebildet sein. Eine Einbettung der Verbindungselemente (z.B. signalführende Leitungen) in das Gewebe der Schutzkleidung stellt sicher, dass keine Spannung führenden Elemente berührt werden können.

Es kann vorgesehen sein, dass leitfähige Strukturen im Gewebe angeordnet sind, wobei die leifähigen Strukturen als Sensoren für elektrische und / oder magnetische Felder ausgebildet sind.

In einer Ausführungsform kann das Gewebe als leitfähiges Gewebe gebildet sein und als Sensor für elektrische und / oder magnetische Felder ausgebildet sein.

Die leitfähigen Strukturen und / oder das leitfähige Gewebe können zwischen zwei isolierenden Schichten angeordnet sein, derart, dass eine Überbrückung von zwei Potenzialen vermieden wird. Eine Überbrückung kann zu einer Personengefährdung (durch elektrischen Schlag, Kurzschluss oder daraus resultierenden Folgen) führen, was durch den sandwichartigen Aufbau der leitfähigen Strukturen und / oder des leitfähigen Gewebes vermieden werden soll.

Die leitfähigen Strukturen können beliebig verzweigen, ein-, zwei- und / oder dreidimensional kontaktiert und kombiniert werden.

Die Recheneinrichtung kann eingerichtet sein, ein weiteres Ausgabesignal an eine externe Einrichtung zu übertragen. Die Übertragung kann auch drahtlos erfolgen.

Die Kleidung kann einen Vitalsensor aufweisen, der eingerichtet ist, eine Vitalfunktion eines Nutzers zu bestimmen und der mit der Recheneinrichtung verbunden ist, wobei die Recheneinrichtung eingerichtet ist, die Vitalfunktion auszuwerten. Die Recheneinrichtung kann weiterhin eingerichtet sein, die Vitalfunktion an die externe Einrichtung zu übermitteln. Es können mehrere Vitalsensoren vorgesehen sein, die verschiedene Vitalfunktionen des Nutzers überwachen.

Die Recheneinrichtung kann weiterhin konfiguriert sein, bei Berührung von leitfähigen, Potenzial führenden Teilen oder einer Überbrückung von Potenzialdifferenzen oder bei Überschreitung von Grenzen bei der Überbrückung von Potenzialdifferenzen automatisch eine Alarmfunktion auszulösen.

Die Schutzkleidung kann Schutzelemente aufweisen, derart, dass die Schutzkleidung gegen elektrostatische Entladung immun ist und nicht beeinflusst werden kann. Auf der Schutzkleidung kann eine gering leitfähige Beschichtung gebildet sein. Es können hochimpedante Übergänge in der Schutzkleidung gebildet sein, die so geartet sind, dass sich keine statischen Ladungen auf dieser ausbilden. Auch kann die Leitfähigkeit so eingestellt sein, dass sich statische Aufladungen innerhalb kurzer Zeit (wenige Sekunden) abbauen.

Die Schutzkleidung kann ausgebildet sein, den Schutz der Elektronik zu gewährleisten gegen Schmutz und Feuchtigkeit oder beim Waschen und Reinigen.

### Beschreibung von Ausführungsformen

im Folgenden werden beispielhafte Ausführungsformen beschrieben. Es zeigen:
- Fig. 1: eine schematische Darstellung eines Messsystems und
- Fig. 2: eine schematische Darstellung einer Schutzkleidung mit dem Messsystem.

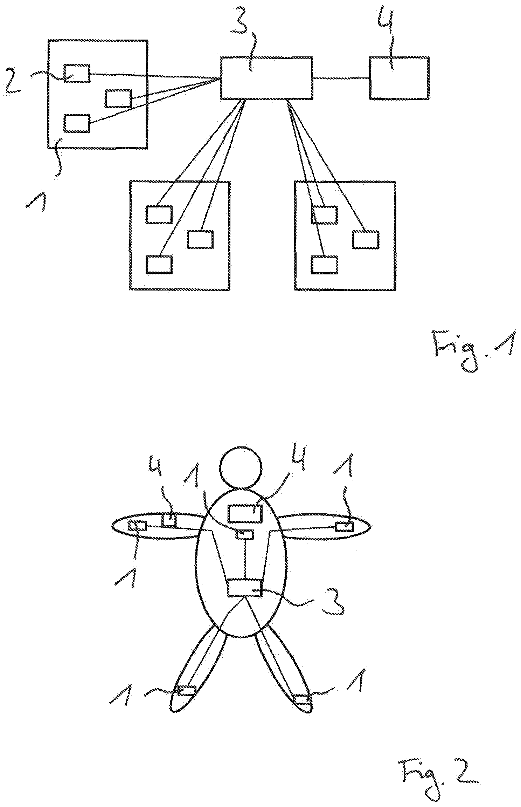

Fig. 1 zeigt eine schematische Darstellung eines Messsystems mit einem Sensorfeld 1, das drei Sensorelemente 2 umfasst, jeweils ein Sensor für die entsprechende Raumrichtung bzw. Koordinatenachse. Die Sensorelemente 2 sind mit einer Recheneinheit 3 (z.B. einem Microprozessor) verbunden. Jeder Sensor 2 misst für sich die Feldstärke, dass Messsignal wird in der Recheneinheit 3 hinsichtlich der Änderung der elektrischen Feldstärke ausgewertet. Aus allen drei Messwerten kann aufgrund der Änderung der elektrischen Feldstärke sowie aus der Höhe der gemessenen Feldstärke auf die Distanz zum Spannung führenden Leiter geschlossen werden. Die Recheneinheit 3 ist mit einer Signalquelle 4 verbunden.

Fig. 2 zeigt eine schematische Darstellung einer Schutzkleidung. Sensorfelder 1 sind in Hand- und Fußbereichen sowie im Brustbereich angeordnet. Signalquellen 4 sind an der Brust sowie an einem Arm angeordnet. Aufgrund der Auswertung der Unfallstatistiken sind die Extremitäten Arme und Beine, Hände sowie der Brust und Rückenbereich besonders gefährdet bei Arbeiten an Schaltanlagen bzw. in der Nähe Spannung führender Betriebsmittel. Daher sind die Sensorelemente direkt im Bereich der Extremitäten angeordnet.

Das Gesamtsystem besteht aus mehreren Einzelsensoreinheiten (Sensorelementen), die an ein gemeinsames Rechnersystem (Recheneinheit 3) angeschlossen sind. Die Signalleitungen zwischen dem Mikrorechner 3 und den Sensoreinheiten 2 sind entweder mit metallischen Leitern oder Glas-/Kunststofffasern angebunden. Dabei sind die Leitungen in den Stoff, Gewebe, so eingebunden, dass diese weder die Bewegung des Arbeitenden behindern, noch metallische Strukturen berühren können, gegen schädigende Einflüsse von außen dadurch geschützt. Die einzelnen Messsignale werden im Mikrorechner 3 ausgewertet und miteinander verrechnet. Bei entsprechender Annährung an einen Spannung führenden Leiter erfolgt eine Alarmierung über einen Signalgeber 4. Der Signalgeber 4 kann entweder im Bereich der Brust, z.B. als Vibrator, auf dem Ärmel für optische Anzeige oder am Helm, bzw. als Zusatzgerät ans Ohr angebracht werden - akustischer Signalgeber. Die Energieversorgung der Recheneinheit 3 und / oder der Sensorelemente 2 kann entweder über Batterien, Akkus oder über Energy Harvesting erfolgen. Als Energiequelle für das Energy Harvesting kann entweder die menschliche Wärme eines Nutzers oder die Ausnutzung der Bewegung des Nutzers dienen.

Der Stand der Technik beschränkt sich im Wesentlichen auf die Vorgabe eines IP Codes, der den Berührungsschutz innerhalb und an elektrischen Betriebsmitteln beschreibt. Dieser IP Code berücksichtigt nicht, dass an und in elektrischen Schaltanlagen und Betriebsmitteln gearbeitet wird und dabei ggf. sogar Schutzabdeckungen demontiert werden müssen. Darüber hinaus wird bei Arbeiten an oder in elektrischen Betriebsmitteln häufig mit Gegenständen gearbeitet (Leitungen, Schraubendrehern, Blindnieten, etc.), die leicht in eine Gefahrenzone eindringen können und kleiner sind als der für die jeweilige Schutzzone definierte IP Schutzgrad es zulässt.

Auch die häufig definierte Forderung nach "Fingersicherheit" und "Handrücksicher" im Bereich der Elektrotechnik reicht nur zur Vermeidung der zufälligen Berührung aus, sofern keine Abdeckungen weggebaut oder gezielte Arbeiten an elektrischen Anlagen ausgeführt werden.

Das zuvor beschriebene System bietet die Möglichkeit der Erkennung von spannungsführenden Bauteilen sowie die Klassifizierung der Spannungshöhe. Damit wird eine Beurteilung möglich, ob die auftretenden Berührungsspannung Personen gefährdend sind. Somit kann eine Warnung bei Annäherung an Spannung führende Betriebsteile generiert werden, im Fall der Berührung Spannung führender Betriebsteile kann eine (Notfall)-meldung generiert werden, die eine Hilfemaßnahme einleitet. Damit lassen sich die Unfallzahlen im Bereich der Niederspannung hinsichtlich der Berührung Spannung führender Elemente deutlich verringern. Allerdings ist das hier vorgestellte System auch in anderen Spannungsebenen einsetzbar.

Eine Kombination des Messsystems mit Vitalsensoren ermöglicht umgehend die Analyse, ob Spannung führende Elemente berührt wurden sowie die Auswirkungen auf den Nutzer, beispielsweise auf Puls, Blutdruck und Durchströmungen der Adern sowie Atemfrequenz, zu analysieren und ggf. sogar an Smartphone, WLAN oder anderer Kommunikationstechnik weiterzuleiten.

## Patentansprüche

1. Schutzkleidung, wobei:
- an der Kleidung mehrere Sensorfelder (1) angeordnet sind,
- jedes Sensorfeld (1) zwei, drei oder mehrere Sensoren (2) aufweist,
- für jedes Sensorfeld (1) gilt, dass die zwei, drei oder mehreren Sensoren (2) paarweise zueinander einen Abstand von weniger als 20 cm aufweisen,
- die Sensoren (2) eingerichtet sind, eine elektrische Feldstärke zu bestimmen,
- die Sensoren (2) mit einer Recheneinrichtung (3) verbunden sind, die eingerichtet ist, von den Sensoren (2) ermittelte Messwerte auszuwerten und ein Signal abzugeben, falls ein vorbestimmter Schwellwert überschritten wird, und
- die Recheneinrichtung (3) weiterhin eingerichtet ist, aus den Messwerten einen Gradienten eines elektrischen Feldes bezüglich einer räumlichen Orientierung zu bestimmen.

2. Schutzkleidung nach Anspruch 1 3, wobei die Sensorfelder (1) in einem Handbereich, einem Fußbereich, einem Brustbereich und / oder einem Rückenbereich der Kleidung angeordnet sind.

3. Schutzkleidung nach einem der vorangehenden Ansprüche, wobei Verbindungselemente, mittels derer die Sensoren (2) mit der Recheneinrichtung (3) verbunden sind, von einem Gewebe der Kleidung umgeben sind, im Gewebe integriert sind oder das Gewebe der Kleidung selbst bilden.

4. Schutzkleidung nach Anspruch 3 5, wobei die Verbindungselemente als metallische Leiter, als Glasfasern, als Kunststofffasern oder als leitfähige Textilfasern gebildet sind.

5. Schutzkleidung nach Anspruch 3 oder 4, wobei leitfähige Strukturen im Gewebe angeordnet sind, wobei die leifähigen Strukturen als Sensoren (2) für elektrische und / oder magnetische Felder ausgebildet sind.

6. Schutzkleidung nach einem der Ansprüche 3 bis 5, wobei das Gewebe als leitfähiges Gewebe gebildet ist und als Sensor für elektrische und / oder magnetische Felder ausgebildet ist.

7. Schutzkleidung nach Anspruch 5 oder 6, wobei die leitfähigen Strukturen oder das leitfähige Gewebe zwischen zwei isolierenden Schichten angeordnet sind, derart, dass eine Überbrückung von zwei Potenzialen vermieden wird.

8. Schutzkleidung nach Anspruch 5 oder 7, wobei die leitfähigen Strukturen beliebig verzweigen, ein-, zwei- und dreidimensional kontaktiert und kombiniert werden können.

9. Schutzkleidung nach einem der vorangehenden Ansprüche, weiterhin eine Signalquelle (4) aufweisend, die mit der Recheneinrichtung (3) verbunden ist, wobei die Recheneinrichtung (3) eingerichtet ist, ein Ausgabesignal an die Signalquelle (4) abzugeben.

10. Schutzkleidung nach einem der vorangehenden Ansprüche, wobei die Recheneinrichtung (3) eingerichtet ist, ein weiteres Ausgabesignal an eine externe Einrichtung zu übertragen.

11. Schutzkleidung nach einem der vorangehenden Ansprüche, weiterhin einen Vitalsensor aufweisend, der eingerichtet ist, eine Vitalfunktion eines Nutzers zu bestimmen und der mit der Recheneinrichtung (3) verbunden ist, und wobei die Recheneinrichtung (3) eingerichtet ist, die Vitalfunktion auszuwerten.

12. Schutzkleidung nach einem vorangehenden Ansprüche, die ein Energy Harvesting durch Bewegung oder Körperwärme erlaubt.

13. Schutzkleidung nach einem der vorangehenden Ansprüchen, wobei die Recheneinrichtung (3) konfiguriert ist, bei Berührung von leitfähigen, Potenzial führenden Teilen oder einer Überbrückung von Potenzialdifferenzen oder bei Überschreitung von Grenzen bei der Überbrückung von Potenzialdifferenzen automatisch eine Alarmfunktion auszulösen.

14. Schutzkleidung nach einem der vorangehenden Ansprüche, weiterhin Schutzelemente aufweisend, derart, dass die Schutzkleidung gegen elektrostatische Entladung immun ist und nicht beeinflusst werden kann.

15. Schutzkleidung nach einem der vorangehenden Ansprüche, wobei die Recheneinrichtung (3) konfiguriert ist, aus dem Gradienten des elektrischen Feldes einen Abstand zu einem ein Potenzial führenden Leiter oder Betriebsmittel zu bestimmen.

## Claims

1. Protective clothing, wherein
- a plurality of sensor fields (1) is arranged on the clothing,
- each sensor field (1) has two, three, or more sensors (2),
- for each sensor field (1), the two, three, or more sensors (2) have pairwise a spacing of less than 20 cm from one another,
- the sensors (2) are configured to determine an electric field strength,
- the sensors (2) are connected to a computing device (3) which is configured to evaluate measured values determined by the sensors (2) and to emit a signal if a predetermined threshold value is exceeded, and
- the computing device (3) is further configured to determine from the measured values a gradient of an electric field relative to a spatial orientation.

2. The protective clothing according to Claim 1, wherein the sensor fields (1) are arranged in a hand region, a foot region, a chest region, and/or a back region of the clothing.

3. The protective clothing according to one of the preceding claims, wherein connecting elements, by means of which the sensors (2) are connected to the computing device (3), are surrounded by a woven fabric of the clothing, are integrated in the woven fabric or form the woven fabric of the clothing itself.

4. The protective clothing according to Claim 3, wherein the connecting elements are formed as metallic conductors, as glass fibres, as plastic fibres, or as conductive textile fibres.

5. The protective clothing according to Claim 3 or 4, wherein conductive structures are arranged in the woven fabric, wherein the conductive structures are configured as sensors (2) for electric and/or magnetic fields.

6. The protective clothing according to one of Claims 3 to 5, wherein the woven fabric is formed as a conductive woven fabric and is configured as a sensor for electric and/or magnetic fields.

7. The protective clothing according to Claim 5 or 6, wherein the conductive structures or the conductive woven fabric are arranged between two insulating layers, such that a bridging of two potentials is avoided.

8. The protective clothing according to Claim 5 or 7, wherein the conductive structures can arbitrarily branch out, be contacted, and be combined one-dimensionally, twodimensionally, and three-dimensionally.

9. The protective clothing according to one of the preceding claims, further comprising a signal source (4) which is connected to the computing device (3), wherein the computing device (3) is designed to emit an output signal to the signal source (4).

10. The protective clothing according to one of the preceding claims, wherein the computing device (3) is configured to transmit a further output signal to an external device.

11. The protective clothing according to one of the preceding claims, further comprising a vital sensor which is configured to determine a vital function of a user and which is connected to the computing device (3), and wherein the computing device (3) is configured to evaluate the vital function.

12. The protective clothing according to one of the preceding claims, which permits energy harvesting by movement or body heat.

13. The protective clothing according to one of the preceding claims, wherein the computing device (3) is configured to trigger an alarm function automatically when conductive potential-carrying parts are touched or when potential differences are bridged or when limits are exceeded when potential differences are bridged.

14. The protective clothing according to one of the preceding claims, further comprising protective elements, such that the protective clothing is immune to electrostatic discharge and cannot be influenced.

15. The protective clothing according to one of the preceding claims, wherein the computing device (3) is configured to determine from the gradient of the electric field a spacing from a potential-carrying conductor or operating means.

## Revendications

1. Vêtement de protection, dans lequel :
- plusieurs champs de capteurs (1) sont disposés sur le vêtement ;
- chaque champ de capteur (1) comporte deux, trois ou plus capteurs (2),
- pour chaque champ de capteur (1) les deux, trois ou plus capteurs (2) par paires présentent une distance inférieure à 20 cm les uns des autres,
- les capteurs (2) sont conçus pour déterminer une intensité de champ électrique,
- les capteurs (2) sont connectés à un dispositif informatique (3), qui est configuré pour évaluer des valeurs de mesure déterminées par les capteurs (2) et pour émettre un signal si une valeur seuil prédéterminée est dépassée et
- le dispositif informatique (3) est en outre conçu pour déterminer à partir des valeurs de mesure un gradient d'un champ électrique par rapport à une orientation spatiale.

2. Vêtement de protection selon la revendication 1, dans lequel les champs de capteurs (1) sont disposés dans une zone des mains, une zone des pieds, une zone de la poitrine et/ou une zone du dos du vêtement.

3. Vêtement de protection selon une des revendications précédentes, dans lequel des éléments de liaison, au moyen desquels les capteurs (2) sont connectés au dispositif informatique (3), sont entourés par le tissu du vêtement, sont intégrés dans le tissu ou forment le tissu du vêtement lui-même.

4. Vêtement de protection selon la revendication 3, dans lequel les éléments de liaison sont constitués de conducteurs métalliques, de fibres de verre, de fibres plastiques ou de fibres textiles conductrices.

5. Vêtement de protection selon la revendication 3 ou 4, dans lequel des structures conductrices sont disposées dans le tissu, dans lequel les structures conductrices sont configurées comme des capteurs (2) de champs électriques et/ou magnétiques.

6. Vêtement de protection selon une des revendications 3 à 5, dans lequel le tissu est formé comme un tissu conducteur et est conçu comme un capteur de champs électriques et/ou magnétiques.

7. Vêtement de protection selon la revendication 5 ou 6, dans lequel les structures conductrices ou le tissu conducteur sont disposés entre deux couches isolantes de manière à éviter un pontage de deux potentiels.

8. Vêtement de protection selon la revendication 5 ou 7, dans lequel les structures conductrices peuvent se ramifier de n'importe quelle manière, être contactées en une, deux et trois dimensions et combinées.

9. Vêtement de protection selon une des revendications précédentes, présentant en outre une source de signal (4) qui est connectée au dispositif informatique (3), dans lequel le dispositif informatique (3) est configuré pour délivrer un signal de sortie à la source de signal (4).

10. Vêtement de protection selon une des revendications précédentes, dans lequel le dispositif informatique (3) est configuré pour transmettre un autre signal de sortie à un dispositif externe.

11. Vêtement de protection selon une des revendications précédentes, comprenant en outre un capteur vital qui est conçu pour déterminer une fonction vitale d'un utilisateur et qui est connecté au dispositif informatique (3), et dans lequel le dispositif informatique (3) est conçu pour évaluer la fonction vitale.

12. Vêtement de protection selon une des revendications précédentes, qui permet de récupérer de l'énergie par le mouvement ou la chaleur corporelle.

13. Vêtement de protection selon une des revendications précédentes, dans lequel le dispositif informatique (3) est configuré pour déclencher automatiquement une fonction d'alarme lors du contact avec des pièces conductrices porteuses de potentiel ou pour combler des différences de potentiel ou lorsque des limites sont dépassées lors du pontage de différences de potentiel.

14. Vêtement de protection selon une des revendications précédentes, présentant d'autres éléments de protection, de telle sorte que les vêtements de protection soient insensibles aux décharges électrostatiques et ne puissent être influencés.

15. Vêtement de protection selon une des revendications précédentes, dans lequel le dispositif informatique (3) est configuré déterminer d'après le gradient du champ électrique une distance par rapport à un conducteur ou un équipement conducteur de potentiel.
